# EUROPÄISCHE PATENTSCHRIFT

(11) **EP 0 573 838 B1**
(45) Veröffentlichungstag und Bekanntmachung des Hinweises auf die Patenterteilung: **05.03.1997**
(21) Anmeldenummer: 93108381.0
(22) Anmeldetag: 24.05.1993
(51) Int. Cl.: H01L 23/64, H01L 23/14

(54) **Mehrchipmodul**
Multi-chip-module
Module à plusieurs puces

(30) Priorität: 10.06.1992 DE 4219031
(43) Veröffentlichungstag der Anmeldung: 15.12.1993
(73) Patentinhaber: SIEMENS AKTIENGESELLSCHAFT, 80333 München (DE)
(72) Erfinder: Hönlein, Wolfgang, Dr., W-8025 Unterhaching (DE); Lehmann, Volker, Dr., W-8000 München 21 (DE)

(56) Entgegenhaltungen:
- EP-A- 0 000 384
- EP-A- 0 296 348
- EP-A- 0 528 281
- US-A- 3 962 713
- MCCAFFERY P J '1990 International electronics packaging conference' September 1990 , INTERNATIONAL ELECTRONICS PACKAGING SOCIETY , WHEATON,IL,US * Seite 412, Absatz 4 - Seite 413, Absatz 1 *

## Beschreibung

Die Erfindung betrifft ein Multi-Chip-Modul. Das ist eine Anordnung mit elektronischen Komponenten, wie sie zum platz- und kostensparenden Aufbau von hochintegrierten elektronischen Komponenten zunehmend Anwendung findet. In einer solchen Anordnung werden unterschiedliche elektronische Komponenten, insbesondere digitale und analoge integrierte Schaltkreise, die teilweise auf unterschiedlichen Substraten wie Silizium oder Galliumarsenid realisiert sind, zusammen mit passiven Bauelementen auf einem Träger angeordnet. Die elektronischen Komponenten sind fest mit dem Träger verbunden und entsprechend der vorgesehenen Anwendung untereinander elektrisch verbunden. Als Träger werden zum Beispiel Silizium- oder Keramikträger verwendet.

Für analoge integrierte Schaltungen und zur Entkopplung von digitalen integrierten Schaltungen von Störungen auf Versorgungsleitungen werden Kondensatoren mit Kapazitäten im Bereich von einem nF bis 10 µF benötigt. Kondensatoren in diesem Kapazitätsbereich lassen sich nicht in den integrierten Schaltungen integrieren.

Deshalb werden sie in bekannten Multi-Chip-Modul-Konzepten als diskrete Kondensatorbauelemente auf dem Träger angeordnet. Die Kondensatorbauelemente werden dabei meist in SMD-Bauform verwendet. Diese Lösung ist kosten- und platzaufwendig und führt außerdem dazu, daß die Kondensatoren nicht beliebig nah an die integrierten Schaltungen plaziert werden können. Ferner weisen die diskreten Kondensatorbauelemente eine erheblich größere Bauhöhe auf als die integrierten Schaltungen und begrenzen daher die minimale Bauhöhe der Anordnung.

Der Erfindung liegt das Problem zugrunde, ein Multi-Chip-Modul anzugeben, das einen Kondensator großer spezifischer Kapazität umfaßt und das dennoch in verminderter Bauhöhe realisierbar ist.

Dieses Problem wird erfindungsgemäß gelöst durch eine Anordnung nach Anspruch 1.

Die Anordnung umfaßt erfindungsgemäß einen Kondensator, der auf einem monokristallinen Siliziumsubstrat realisiert ist, dessen Oberfläche mindestens im Bereich des Kondensators durch eine elektrochemische Ätzung in einem fluoridhaltigen, sauren Elektrolyten, in dem das Siliziumsubstrat als Anode verschaltet ist, vergrößert ist. Durch die elektrochemische Ätzung wird die Oberfläche des Siliziumsubstrats auf charakteristische Weise strukturiert. Es entstehen Löcher, die je nach Vorbehandlung des Substrats mehr oder weniger regelmäßig angeordnet sind und die ein hohes Aspektverhältnis bis in den Bereich von etwa 1:400 aufweisen. Auf einer solchen Oberfläche sind durch Abscheidung einer dielektrischen Schicht und einer leitfähigen Schicht als Gegenelektrode Kondensatoren hoher spezifischer Kapazität realisierbar. Solche Kondensatoren auf Siliziumbasis haben typischerweise spezifische Kapazitäten von 10 µFV/mm³. Ein Kondensator mit 10 µF und 10V Nennspannung ist daher auf einer Fläche von etwa 10 mm² bei einem Aspektverhältnis von 1:400 realisierbar.

Elektrochemisches Ätzen von Silizium ist aus der Druckschrift EP-A-0 296 348 bekannt. Die Herstellung von Kondensatoren auf elektrochemisch geätzten Siliziumsubstraten ist in der früheren europäischen Anmeldung EP-A-0 528 281 beschrieben, die nur im Sinne des Artikels 54(3) EPÜ zum Stand der Technik zählt.

Erfindungsgemäß besteht der Träger aus monokristallinem Silizium. Dabei ist die Oberfläche des Trägers mindestens teilweise durch elektrochemisches Ätzen in einem fluoridhaltigen, sauren Elektrolyten, in dem der Träger als Anode verschaltet ist, vergrößert. Der Kondensator ist in dem Träger im Bereich der vergrößerten Oberfläche realisiert. Es liegt im Rahmen der Erfindung, die Größe des Kondensators dabei durch die Geometrie der leitfähigen Schicht zu definieren. Dadurch ist es möglich, andere elektronische Komponenten mindestens teilweise oberhalb des Kondensators anzuordnen. Dadurch wird eine platzsparende Anordnung ermöglicht.

Es liegt dabei im Rahmen der Erfindung, daß ein Teil der Oberfläche des Trägers nicht vergrößert ist und daß in diesem Teil der Oberfläche des Trägers Anschlüsse zur Kontaktierung der Chips angeordnet sind. Dadurch wird eine laterale Trennung von Anschlüssen und Kondensatoren erreicht. Zur elektrischen Verbindung des Kondensators und der integrierten

Schaltung liegt es im Rahmen der Erfindung, an der Oberfläche des Trägers eine Metallisierung vorzusehen. Das Substrat mit der integrierten Schaltung wird so an der Oberfläche des Trägers angeordnet, daß es die Metallisierung mindestens teilweise überlappt. Auf diese Weise ist eine niederohmige elektrische Verbindung zwischen den einzelnen elektronischen Komponenten möglich. Eine solche Anordnung läßt sich durch Flip-Chip-Montage herstellen.

Im folgenden wird die Erfindung anhand der Figuren und der Ausführungsbeispiele näher erläutert.
- Figur 1: zeigt einen Kondensator, der auf einem monokristallinen Siliziumsubstrat realisiert ist, dessen Oberfläche durch anodisches elektrochemisches Ätzen in einem fluoridhaltigen, sauren Elektrolyten vergrößert ist.
- Figur 2: zeigt eine Anordnung mit elektronischen Komponenten, die einen Träger aus monokristallinem Silizium umfaßt, dessen Oberfläche teilweise durch anodische, elektrochemische Ätzung vergrößert ist.
- Figur 3: zeigt eine Anordnung mit elektronischen Komponenten mit einem Träger aus monokristallinem Silizium, dessen Oberfläche durchgehend durch anodische, elektrochemische Ätzung vergrößert ist und in dessen Oberfläche mindestens ein Kondensator realisiert ist.

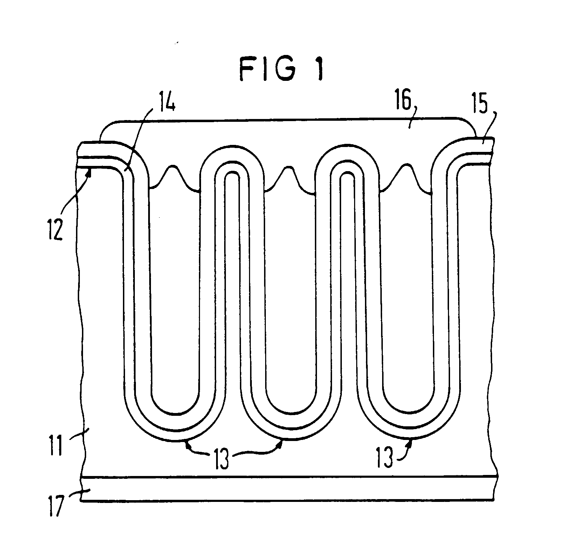

Anhand von Figur 1 wird ein Kondensator erläutert, der auf einem monokristallinen Siliziumsubstrat realisiert ist, dessen Oberfläche mindestens im Bereich des Kondensators durch elektrochemische Ätzungen in einem flouridhaltigen, sauren Elektrolyten, in dem das Siliziumsubstrat als Anode verschaltet ist, vergrößert ist.

Ein Substrat 11 aus n-dotiertem, monokristallinem Silizium, das einen spezifischen Widerstand von zum Beispiel 5 Ohm . cm aufweist, ist an einer Oberfläche 12 mit einer Vielzahl von Lochöffnungen 13 versehen. Die Lochöffnungen 13 weisen einen Durchmesser von zum Beispiel 3 µm und eine Tiefe von zum Beispiel 200 µm auf. Die Lochöffnungen 13 sind mit Hilfe einer elektrochemischen Ätzung gebildet. Als Elektrolyt wird dabei zum Beispiel 6 prozentige Flußsäure (HF) verwendet. Das n-dotierte Substrat wird als Anode mit einem Potential von 3 Volt beaufschlagt. Das Substrat wird von der Rückseite her beleuchtet. Es wird eine Stromdichte von zum Beispiel 10 Milliampere/cm² eingestellt. Bei der elektrochemischen Ätzung ist die Oberfläche 12 mit dem Elektrolyten in Kontakt. Nach ungefähr 150 Minuten Ätzzeit weisen die Lochöffnungen 13 eine Tiefe von 200 µm auf.

Die Oberfläche der Lochöffnungen 13 und der dazwischen verbleibenden Oberfläche 12 ist konform mit einer dielektrischen Schicht 14 bedeckt. Die dielektrische Schicht 14 besteht zum Beispiel aus SiO₂ und weist eine Dicke von zum Beispiel 92 nm auf. Auf der dielektrischen Schicht 14 ist eine leitfähige Schicht 15 angeordnet. Die leitfähige Schicht 15 besteht zum Beispiel aus n-dotiertem Polysilizium. Die leitfähige Schicht 15 bedeckt die dielektrische Schicht 14 vollständig. Die leitfähige Schicht 15 wird durch einen ersten Kontakt 16 kontaktiert. Der erste Kontakt 16 besteht zum Beispiel aus Aluminium. Aufgrund der Oberflächenspannung des Aluminiums besteht der erste Kontakt 16 aus einer durchgehenden Schicht, die im Bereich der Lochöffnungen 13 nur den oberen Teil der leitfähigen Schicht 15 kontaktiert. Die leitfähige Schicht 15 und das Substrat 11 wirken in dem Kondensator als Kondensatorelektroden. Auf einer der Oberfläche 12 abgewandten Oberfläche des Substrats ist ein zweiter Kontakt 17 aus zum Beispiel Aluminium aufgebracht.

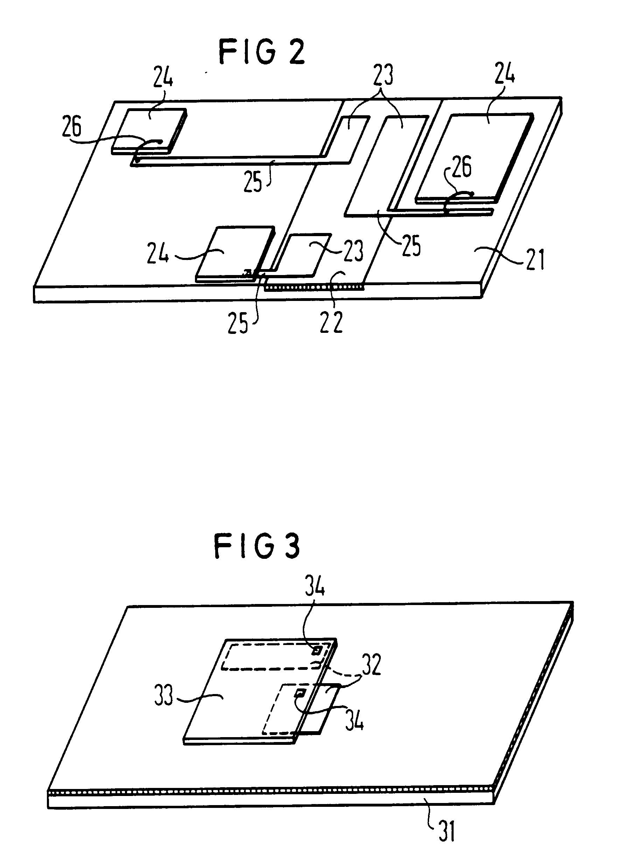

Ein Träger 21 aus monokristallinem Silizium (s. Figur 2) weist einen Bereich 22 in der Oberfläche auf, in der die Oberfläche durch eine elektrochemische Ätzung in einem fluoridhaltigen, sauren Elektrolyten, in dem der Träger als Anode verschaltet ist, vergrößert ist. In diesem Bereich 22 sind Kondensatoren 23 realisiert. Die Größe der Kondensatoren 23 ist dabei durch die Geometrie einer leitfähigen Schicht, die als Kondensatorelektrode wirkt, definiert. Außerhalb des Bereichs 22 sind auf dem Träger 21 elektronische Komponenten z. B. in Substrate integrierte Schaltungen 24 angeordnet. Metallisierungen 25 sind an der Oberfläche der Kondensatoren 23 angeordnet und erstrecken sich auf die Oberfläche des Trägers 21. Dadurch bilden die Metallisierungen 25 gleichzeitig einen Kontakt zu der leitfähigen Schicht des jeweiligen Kondensators 23 und stellen eine Anschlußmöglichkeit für integrierte Schaltungen dar. Dieser Anschluß wird zum Beispiel über Bonddrähte 26 realisiert.

Die elektrische Verbindung zwischen der Metallisierung 25 und einer integrierten Schaltung 24 kann auch dadurch realisiert werden, daß die integrierte Schaltung 24 teilweise oberhalb der Metallisierung 25 angeordnet ist. Der Kontakt erfolgt in diesem Fall über die Rückseite des Substrats, in dem die integrierte Schaltung 24 integriert ist. Eine solche elektrische Verbindung kann zum Beispiel durch Flip-Chip-Montage realisiert werden.

In einem anderen Ausführungsbeispiel (siehe Figur 3) wird ein Träger 31 aus monokristallinem Silizium verwendet, dessen Oberfläche durch eine anodische, elektrochemische Ätzung in einem fluoridhaltigen, sauren Elektrolyten mit einer Lochstruktur versehen und dadurch vergrößert ist. In der Oberfläche sind Kondensatoren 32 realisiert, deren Größe durch die Geometrie der leitfähigen Schicht festgelegt ist. Auf dem Träger 31 ist als elektronische Komponente zum Beispiel eine in einem Substrat integrierte Schaltung 33 angeordnet. Sie überlappt die Kondensatoren ganz oder teilweise. Eine elektrische Verbindung zwischen der integrierten Schaltung 33 und den Kondensatoren 32 ist über eine Metallisierung 34 an der Oberfläche des Trägers 31, die das die integrierte Schaltung 33 enthaltende Substrat von der Rückseite her kontaktiert, realisiert. Diese Ausführungsform erlaubt eine sehr platzsparende Anordnung von Kondensatoren und integrierten Schaltungen.

## Patentansprüche

1. Multi-Chip-Modul,
- bei dem ein Träger (21; 31) aus monokristallinem Silizium vorgesehen ist, dessen Oberfläche mindestens in einem Bereich durch elektrochemische Ätzung in einem fluoridhaltigen, sauren Elektrolyten, in dem der Träger als Anode verschaltet ist, vergrößert ist,
- bei dem auf der vergrößerten Oberfläche mindestens ein Kondensator (23;32) angeordnet ist, der eine dielektrische Schicht, die auf der vergrößerten Oberfläche angeordnet ist, und eine leitfähige Schicht, die auf der dielektrischen Schicht angeordnet ist, umfaßt, wobei der Träger und die leitfähige Schicht als Kondensatorelektroden wirken.

2. Multi-Chip-Modul nach Anspruch 1,
bei dem die Größe des Kondensators durch die Geometrie der leitfähigen Schicht definiert ist.

3. Multi-Chip-Modul nach Anspruch 1 oder 2,
bei dem ein Teil der Oberfläche des Trägers nicht vergrößert ist und in diesem Teil der Oberfläche des Trägers Anschlüsse zur Kontaktierung der Chips angeordnet sind.

4. Multi-Chip-Modul nach einem der Ansprüche 1 bis 3,
- bei dem zur elektrischen Verbindung von Kondensator (23, 32) und anderen elektronischen Komponenten (24, 33) an der Oberfläche des Trägers (21, 31) eine Metallisierung (25, 34) angeordnet ist und
- bei der mindestens ein Substrat mit einer elektronischen Komponente (24; 33) so an der Oberfläche des Trägers (21, 31) angeordnet ist, daß es die Metallisierung (25; 34) mindestens teilweise überlappt.

5. Multi-Chip-Modul nach Anspruch 4,
bei der mindestens eine elektronische Komponente mindestens teilweise oberhalb des Kondensators (32) angeordnet ist.

## Claims

1. Multi-chip module,
- in which there is provided a carrier (21; 31) which is made of monocrystalline silicon and whose surface is enlarged at least in one region by electrochemical etching in a fluoride-containing, acidic electrolyte, in which the carrier is connected as the anode,
- in which at least one capacitor (23; 32) is arranged on the enlarged surface and comprises a dielectric layer, which is arranged on the enlarged surface, and a conductive layer, which is arranged on the dielectric layer, the carrier and the conductive layer acting as capacitor electrodes.

2. Multi-chip module according to Claim 1,
in which the size of the capacitor is defined by the geometry of the conductive layer.

3. Multi-chip module according to Claim 1 or 2,
in which part of the surface of the carrier is not enlarged and connections for making contact with the chips are arranged in this part of the surface of the carrier.

4. Multi-chip module according to one of Claims 1 to 3,
- in which a metallization layer (25, 34) is arranged on the surface of the carrier (21, 31), for the electrical connection of the capacitor (23, 32) and other electronic components (24, 33), and
- in which at least one substrate having an electronic component (24; 33) is arranged on the surface of the carrier (21; 31) in such a way that it at least partially overlaps the metallization layer (25; 34).

5. Multi-chip module according to Claim 4,
in which at least one electronic component is arranged at least partially above the capacitor (32).

## Revendications

1. Module à plusieures puces,
- pour lequel un support (21, 31) en silicium monocristallin est prévu, dont la surface est agrandie dans au moins une zone par décapage électrochimique dans un électrolyte acide fluoruré, dans lequel le support sert d'anode,
- sur la surface agrandie duquel au moins un condensateur (23, 32) est disposé qui comprend une couche diélectrique disposée sur la surface agrandie et une couche conductrice disposée sur la couche diélectrique, le support et la couche conductrice fonctionnant comme électrodes de condensateur.

2. Module à plusieures puces selon la revendication 1,
dans lequel la taille du condensateur est définie en fonction de la géométrie de la couche conductrice.

3. Module à plusieures puces selon la revendication 1 ou 2,
dans lequel une partie de la surface du support n'est pas agrandie et des raccords pour connecter les puces sont disposés dans cette partie de la surface du support.

4. Module à plusieurs puces selon l'une des revendications 1 à 3,
- pour lequel une métallisation (25,34) est disposée sur la surface du support (21, 31) pour la connexion électrique du condensateur (23, 32) et d'autres composantes électroniques (24, 33) et
- pour lequel au moins un substrat avec une composante électronique (24, 33) est disposée à la surface du support de telle sorte qu'il recouvre au moins partiellement la métallisation (25, 34).

5. Module à plusieures puces selon la revendication 4,
pour lequel au moins une composante électronique est disposée au moins partiellement au-dessus du condensateur (32).
